# EUROPEAN PATENT APPLICATION

(11) **EP 4 593 057 A2**
(43) Date of publication of application: **30.07.2025**
(21) Application number: 25151960.9
(22) Date of filing: 15.01.2025
(51) Int. Cl.: H01J 37/317

(54) **FOCUSED ION BEAM SYSTEM**

(30) Priority: 23.01.2024 JP 2024008024
(71) Applicant: Jeol Ltd., Akishima-shi, Tokyo 196-8558 (JP)
(72) Inventor: SAKUTA, Norimasa, Tokyo (JP); FUKUDA, Tomohisa, Tokyo (JP); MIZUNO, Noriaki, Tokyo (JP)
(74) Representative: Boult Wade Tennant LLP

(57) **Abstract**

There is provided a focused ion beam (FIB) system capable of exhausting gas remaining in a nozzle. The FIB system (100) is operative to mill a sample (S) by irradiating it with an ion beam and includes: the nozzle (42) for blowing the gas (2) from a blowoff port (422) against the sample (S) to deposit a film; and a tank (44) for supplying the gas (2) into the nozzle (42). The nozzle (42) is provided with exhaust holes (426) for exhausting the gas (2) in the nozzle (42).

## Description

### BACKGROUND OF THE INVENTION

### 1. Field of the Invention

The present invention relates to a focused ion beam (FIB) system.

### 2. Description of the Related Art

In a focused ion beam (FIB) system, a sample can be milled by scanning its surface with a focused ion beam. Furthermore, in this FIB system, a film can be deposited on the surface of the sample by irradiating the sample with an electron beam or an ion beam while blowing a gaseous compound against and around the sample surface. With a cryo-FIB system in which a cooled sample is milled, a film can be deposited on the surface of the sample only by blowing a gaseous compound against the sample without any beam irradiation.

In Patent document 1, there is disclosed a focused ion beam system equipped with a gas gun for blowing a gaseous compound against a sample. The gas gun includes a gas tank for accommodating a gas source as well as a gas nozzle. When a film is deposited, the gas nozzle is moved by an air cylinder from its retracted position so as to approach a height hundreds of micrometers away from the milled point on the sample. A gas seal plug is mounted in the gas tank. Gas can be blown against the sample by opening the gas seal plug.

### Citation List

### Patent Documents

Patent document 1: JP 2007-134520 A

With the above-described gas gun, if the gas tank is closed with the gas seal plug, gas stays inside the gas nozzle.

### SUMMARY OF THE INVENTION

One aspect of the focused ion beam system associated with the present invention is adapted to mill a sample by irradiating it with an ion beam and comprises:
a nozzle for blowing a gas, which is used to deposit a film, from a blowoff port against the sample;
a tank for supplying the gas into the nozzle; and
exhaust holes formed in the nozzle to exhaust the gas in the nozzle.

In this focused ion beam system, the nozzle has the exhaust holes and so the gas staying in the nozzle can be exhausted.

### BRIEF DESCRIPTION OF THE DRAWINGS

FIG. 1 is a schematic diagram illustrating one example of configuration of a focused ion beam (FIB) system associated with a first embodiment of the present invention.
FIG. 2 is a schematic cross-sectional view of a gas ejector.
FIGS. 3 and 4 are cross-sectional views similar to FIG. 2, illustrating the operation of the FIB system of FIG. 1.
FIGS. 5 and 6 are schematic cross-sectional views of a modification of the FIB system of FIG. 1.
FIG. 7 is a schematic diagram illustrating one example of configuration of an FIB system associated with a second embodiment of the invention.
FIG. 8 is a schematic cross-sectional view of a gas ejector.
FIGS. 9 and 10 are schematic cross-sectional views illustrating the operation of the FIB system of FIG. 7.
FIG. 11 is a schematic diagram illustrating one example of configuration of an FIB system associated with a third embodiment of the invention.
FIG. 12 is a schematic diagram illustrating one example of configuration of an FIB system associated with a fourth embodiment of the invention.
FIGS. 13 and 14 are schematic cross-sectional views illustrating the operation of the FIB system of FIG. 12.
FIG. 15 is a schematic diagram illustrating one example of configuration of an FIB system associated with a fifth embodiment of the invention.
FIGS. 16 and 17 are schematic cross-sectional views illustrating the operation of the FIB system of FIG. 15.

### DETAILED DESCRIPTION OF THE INVENTION

The preferred embodiments of the present invention are hereinafter described in detail with reference to the drawings. It is to be understood that the embodiments provided below do not unduly restrict the scope and content of the present invention delineated by the appended claims and that not all the configurations described below are essential constituent components of the invention.

### 1. First Embodiment

### 1.1. Focused Ion Beam System

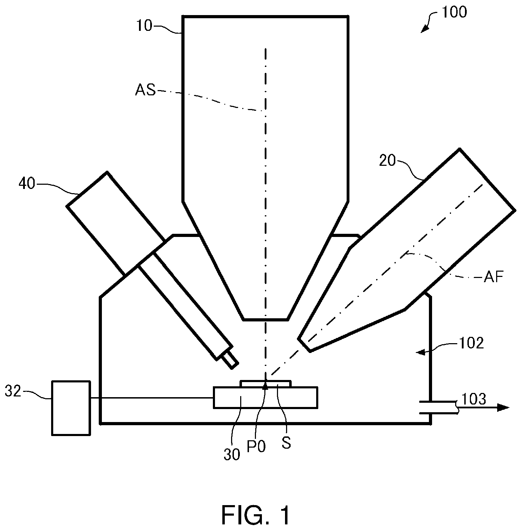

A focused ion beam (FIB) system associated with a first embodiment is first described by referring to FIG. 1, which shows one example of configuration of the FIB system, 100. As shown, the FIB system 100 includes an SEM (scanning electron microscope) column 10, an FIB (focused ion beam) column 20, a sample stage 30, a cooling mechanism 32, and a gas ejector 40. Because the FIB system 100 is equipped with both the SEM column 10 and the FIB column 20, the system permits milling and observation of a sample S.

The SEM column 10 that irradiates the sample S with an electron beam operates to form and scan an electron probe. The SEM column 10 includes an electron gun for emitting the electron beam and an electron optical system that focuses the electron beam into the electron probe and scans it. The electron beam emitted from the electron gun travels along the optical axis AS of the SEM column 10 and strikes the sample S. In the FIB system 100, an SEM image can be derived by scanning the sample S with the electron probe and detecting with an electron detector (not shown) electrons released from the sample S.

The FIB column 20 that operates to irradiate the sample S with an ion beam forms and scans the ion beam. The FIB column 20 includes an ion gun for emitting the ion beam and an ion optical system for focusing and scanning the ion beam. The ion beam released from the ion gun travels along the optical axis AF of the FIB column 20 and strikes the sample S. The FIB system 100 can mill the sample S by scanning the sample S with the focused ion beam.

The sample stage 30 mechanically supports the sample S, which in turn is disposed in a sample chamber 102. The sample chamber 102 is evacuated to and maintained at a vacuum or subatmospheric condition by an exhaust system 103 that includes vacuum pumping equipment, an exhaust pipe interconnecting the sample chamber 102 and the vacuum pumping equipment, and valves none of which are shown.

In the FIB system 100, milling and observation of the sample S are carried out at the point of intersection P0 between the optical axes AS and AF. The sample stage 30 includes a drive mechanism for moving the sample S horizontally and vertically, as well as a tilt mechanism for tilting the sample S. The sample stage 30 may be so configured that it can support a sample holder which can be shared between the FIB system 100 and a transmission electron microscope.

The cooling mechanism 32 cools the sample stage 30, resulting in cooling of the sample S. The cooling mechanism 32 includes, for example, a tube through which a gas flows and a refrigerant tank for cooling the gas. The cooling mechanism 32 cools the sample stage 30 by passing the gas cooled with the refrigerant tank filled with liquid nitrogen, for example, through the tube in thermal communication with the sample stage 30. In addition, the cooling mechanism 32 may include, for example, a refrigerant tank and thermal conductive lines that thermally connect the refrigerant tank with the sample stage 30, whereby the sample stage 30 can be cooled.

Because the FIB system 100 is equipped with the cooling mechanism 32 for cooling the sample stage 30 in this way, the system can be used as a cryo FIB capable of milling the sample S while cooling it. Therefore, with the FIB system 100, biological samples in frozen state, battery materials, and so on can be milled and observed.

The gas ejector 40 blows a gas, which is used to deposit a film, against the sample S. Where a film is deposited on the sample S at room temperature, the sample S is irradiated with an electron beam or an ion beam while blowing the gas against the sample S with the gas ejector 40. Secondary electrons emanating from the irradiated sample S decompose the gas into the deposited film material and gas components. Consequently, the deposited film material adheres to the sample S, depositing the film. Where a film is deposited on the sample S that is being cooled, a gas is blown against the sample S without any beam irradiation. The gas adheres to the surface of the cooled sample S. Consequently, a film can be deposited.

### 1.2. Gas Ejector

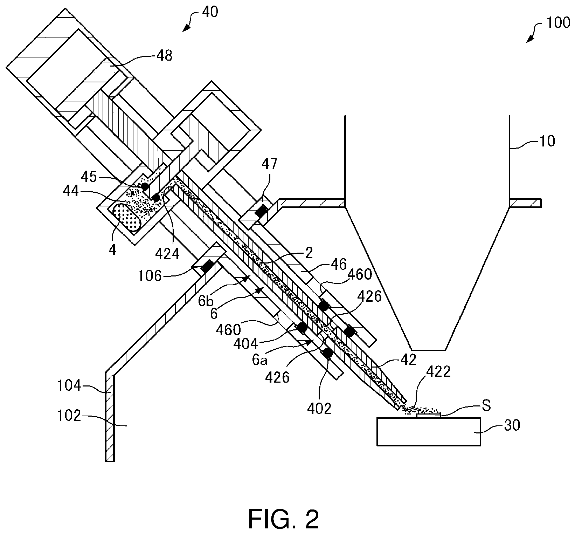

FIG. 2 is a schematic cross-sectional view of the gas ejector 40 which has a nozzle 42, a reservoir tank 44, a valve 45, a receiving tube 46, and a drive mechanism 48. FIG. 2 illustrates a state in which the gas 2 is being blown against the sample S with the nozzle 42.

A gas source 4 in solid or liquid form is received in the reservoir tank 44. Examples of the gas source 4 include carbon compounds, tungsten compounds, and platinum compounds. The gas 2 produced from the gas source 4 is supplied from the reservoir tank 44 into the nozzle 42 through the valve 45. The gas 2 is used to deposit a film.

The valve 45 is mounted between the nozzle 42 and the reservoir tank 44. The gas 2 can be supplied into the nozzle 42 from a supply port 424 of the nozzle 42 by opening the valve 45. As a result, the gas 2 is blown out of a blowoff port 422 of the nozzle 42. The supply of the gas 2 into the nozzle 42 can be stopped by closing the valve 45. The valve 45 is opened and closed by the power of an air cylinder, for example. Note that no restriction is imposed on the structure of the valve 45.

The nozzle 42 is a cylindrical member for blowing the gas 2 from the blowoff port 422 against the sample S. In the FIB system 100, the reservoir tank 44 can be placed at a remote position from the sample S by using the nozzle 42 that is thin and long. For example, in the example of FIG. 2, the reservoir tank 44 is located outside the sample chamber 102 and so the reservoir tank 44 can be easily refilled with the gas source 4.

The nozzle 42 is connected to the reservoir tank 44 via the valve 45. The nozzle 42 has a rear end provided with the supply port 424 via which the gas 2 is supplied from the reservoir tank 44 into the nozzle 42. The supply port 424 is opened and closed by the valve 45.

The blowoff port 422 is formed in the front end of the nozzle 42. The gas 2 supplied from the supply port 424 in the rear end of the nozzle 42 passes through the nozzle 42 and is blown out of the blowoff port 422 formed in the front end of the nozzle 42.

The nozzle 42 is provided with exhaust holes 426 for exhausting the gas 2 in the nozzle 42. The exhaust holes 426 are located between the blowoff port 422 and the supply port 424. The exhaust holes 426 extend through the side wall of the nozzle 42. In the illustrated example, there are two exhaust holes 426 but there is no restriction on the number of exhaust holes 426. Each exhaust hole 426 is greater in diameter than the blowoff port 422.

The exhaust holes 426 are in communication with a gap 6 lying between the nozzle 42 and the receiving tube 46. When the nozzle 42 of FIG. 2 is placed at the position where a film is to be formed, the exhaust holes 426 are in communication with a sealed chamber 6a formed using a front O-ring 402 and a rear O-ring 404. The sealed chamber 6a is a space positioned between the O-rings 402 and 404 which hermetically seal the space between the nozzle 42 and the receiving tube 46.

The receiving tube 46 receives the nozzle 42 and is a cylindrical member that is greater in diameter than the nozzle 42. The nozzle 42 can move through the receiving tube 46.

Two grooves for the O-rings are formed in the inner wall of the receiving tube 46. The front O-ring 402 is mounted in one groove. The rear O-ring 404 is mounted in the other groove. The front O-ring 402 is located closer to the front end of the nozzle 42 than is the rear O-ring 404. The nozzle 42 can slide in the receiving tube 46 via the O-rings 402 and 404.

The gap 6 between the nozzle 42 and the receiving tube 46 is partitioned into the sealed chamber 6a and the exhaust chamber 6b by the O-rings 402 and 404. The sealed chamber 6a is a space between the O-rings 402 and 404. The exhaust chamber 6b constitutes an exhaust path for exhausting the gas 2 in the nozzle 42 and is in communication with through-holes 460 extending through the side wall of the receiving tube 46. The exhaust chamber 6b is located closer to the rear end of the nozzle 42 than is the rear O-ring 404.

The receiving tube 46 is provided with the through-holes 460 which are two in number in the illustrated example. There is no restriction regarding the number of through-holes 460. Each through-hole 460 is greater in diameter than the blowoff port 422 and than each exhaust hole 426. One opening of each through-hole 460 is connected to the exhaust chamber 6b, while the other opening is connected to the sample chamber 102.

The receiving tube 46 is connected to a flange 47, which in turn is mounted in a hole formed in an enclosure 104 defining the sample chamber 102. An O-ring 106 provides a hermetic seal between the flange 47 and the enclosure 104.

The drive mechanism 48 supports the nozzle 42 such that the nozzle 42 can move between the position for film deposition and a retractive position. The position for film deposition is in the vicinity of the sample S. At this position, the gas 2 can be blown from the blowoff port 422 against the sample S. The retractive position is different from the position for film deposition and remote from the sample S. The distance between the retractive position and the sample S is greater than that between the position for film deposition and the sample S.

The drive mechanism 48 moves the nozzle 42. The drive mechanism 48 is an air cylinder, for example, which rectilinearly moves the nozzle 42 along its central axis. No restrictions are imposed on the structure of the drive mechanism 48 as long as it can move the nozzle 42 between the position for film deposition and the retractive position. For instance, the drive mechanism 48 is a single-axis actuator assembly including a driver device such as an air cylinder or an electric motor and a power transmission mechanism such as a linear guide. The drive mechanism 48 may permit manual movement of the nozzle 42.

### 1.3. Operation

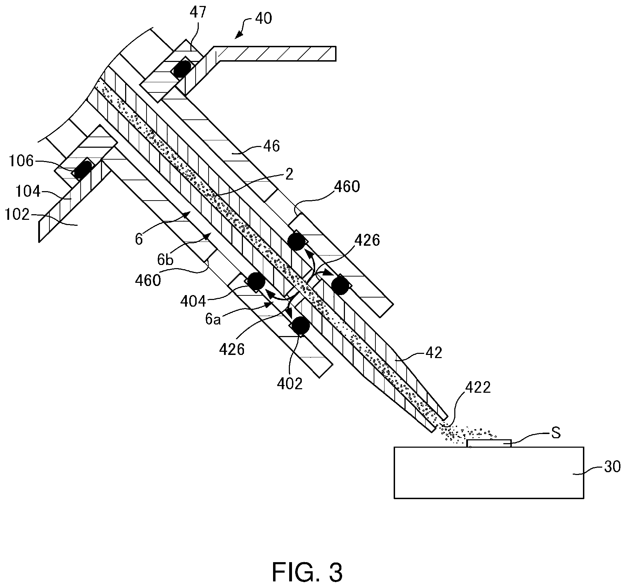

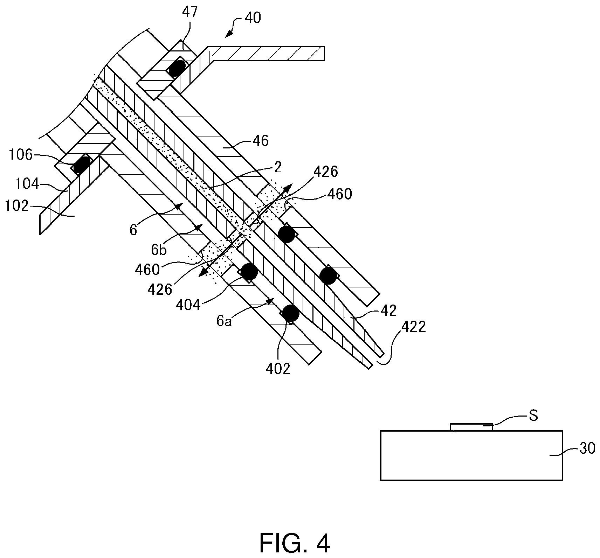

FIGS. 3 and 4 illustrate the operation of the focused ion beam (FIB) system 100. FIG. 3 illustrates a state in which the nozzle 42 is in the position for film deposition. FIG. 4 illustrates a state in which the nozzle 42 is in its retractive position.

In the FIB system 100, the nozzle 42 can be moved between the position for film deposition and the retractive position by means of the drive mechanism 48. Where a film is deposited on the sample S, the nozzle 42 is placed in the position for film deposition. Consequently, the blowoff port 422 of the nozzle 42 can be placed close to the sample S. By opening the valve 45 in this position for film deposition, the gas 2 is blown out of the blowoff port 422 and a film can be deposited on the sample S. By closing the valve 45, the process of the deposition can be brought to a stop. After closing the valve 45, the nozzle 42 is placed in its retractive position. As a result, the nozzle 42 can be placed at a remote position from the sample S, and the space in the vicinity of the sample S can be effectively utilized.

Since the receiving tube 46 is stationary, the distance between respective ones of the through-holes 460 in the receiving hole 46 and of the exhaust holes 426 in the nozzle 42 varies according to movement of the nozzle 42. In particular, the distance between respective ones of the exhaust holes 426 and the through-holes 460 as taken when the nozzle 42 is in its retractive position is less than the same distance but taken when the nozzle 42 is in the position for film deposition.

If the nozzle 42 is placed in the position for film deposition as shown in FIG. 3, the exhaust holes 426 are placed in communication with the sealed chamber 6a, thus closing the exhaust path. At this time, the amount of the gas 2 exhausted from the exhaust holes 426 is quite small. Most of the gas 2 supplied from the supply port 424 is blown out from the blowoff port 422. Consequently, the gas 2 can be blown against the sample S and thus a film can be deposited on the sample S.

If the nozzle 42 is placed in its retractive position as shown in FIG. 4, the exhaust holes 426 are placed in communication with the exhaust chamber 6b. Thus, the exhaust holes 426, exhaust chamber 6b, and through-holes 460 together constitute the exhaust path. Therefore, by moving the nozzle 42 into its retractive position, the exhaust path is opened. The gas 2 remaining in the nozzle 42 can be exhausted into the sample chamber 102 via the exhaust path.

If the nozzle 42 is placed in its retractive position, the exhaust holes 426 and the through-holes 460 register as viewed along the central axis of the exhaust holes 426. Accordingly, the gas 2 exhausted from the exhaust holes 426 can be efficiently exhausted into the sample chamber 102 via the through-holes 460.

Each exhaust hole 426 is greater in diameter than the blowoff port 422. Also, each through-hole 460 is greater in diameter than the blowoff port 422. The exhaust holes 426 are plural in number. Also, the through-holes 460 are plural in number. The conductance of the exhaust path can be increased by increasing the diameters of the exhaust holes 426 and of the through-holes 460 and providing the plural exhaust holes 426 and the plural through-holes 460. The conductance is an index representing the degree of ease with which a gas flows. For the same pressure difference, as the conductance increases, the flow rate of the gas increases.

In the FIB system 100, if the nozzle 42 is placed in its retractive position, the conductance of the exhaust path is greater than that of the front end portion of the nozzle 42 which extends from the exhaust holes 426 to the blowoff port 422. Therefore, if the nozzle 42 is placed in its retractive position, the amount of the gas 2 exhausted from the exhaust path can be made greater than the amount of the gas 2 exhausted from the blowoff port 422.

The through-holes 460 do not face the sample S. That is, the central axis of the through-holes 460 does not intersect with the sample S. The degree of vacuum in the sample chamber 102 is in the molecular flow region on the order of 10⁻⁵ to 10⁻⁶ Pa in which gas molecules travel nearly straight. Therefore, the gas molecules which are exhausted from the through-holes 460 into the sample chamber 102 and go toward the sample S can be made quite small in number. As a result, the possibility that the gas 2 will adhere to the sample S after being exhausted into the sample chamber 102 from the through-holes 460 can be reduced.

### 1.4. Advantageous Effects

The FIB system 100 includes: the nozzle 42 for blowing the gas 2, which is used to deposit a film, from the blowoff port 422 against the sample S; and the reservoir tank 44 for supplying the gas 2 into the nozzle 42. The nozzle 42 has the exhaust holes 426 for exhausting the gas 2 in the nozzle 42. Consequently, the FIB system 100 is capable of exhausting the gas 2 staying in the nozzle 42.

Since the nozzle 42 is thin and long, even if the valve 45 is closed, the gas 2 will remain in the nozzle 42. If the remaining gas 2 leaks out of the nozzle 42 and reaches the surface of the sample S, a film is deposited on the surface of the sample S in an unintended manner. Especially, in a cryo-FIB process, a film is deposited without any beam irradiation. Therefore, the gas 2 leaking out of the nozzle 42 may result in a film which is deposited so thick that an observation or analysis using an electron microscope is adversely affected. Furthermore, if the sample S is at room temperature, a film may be deposited thickly on the surface of the sample S according to the type of the gas 2.

In contrast, in the FIB system 100, the gas 2 remaining in the nozzle 42 can be exhausted and so it is possible to prevent a film from being deposited on the surface of the sample S so thick that an observation or analysis using an electron microscope is adversely affected.

Furthermore, if the gas 2 remains in the nozzle 42, when a film is deposited on the surface of the sample S, the components of the gas 2 remaining in the nozzle 42 are blown against the sample S. This makes it impossible to blow gas 2 of high purity against the sample S. In contrast, in the FIB system 100, the gas 2 remaining in the nozzle 42 can be exhausted and so the interior of the nozzle 42 can be maintained in a clean state. Therefore, during deposition of a film, gas 2 of high purity can be blown against the sample S.

The FIB system 100 includes the drive mechanism 48 capable of moving the nozzle 42 between the position for film deposition where the gas 2 can be blown from the blowoff port 422 against the sample S and the retractive position different from the position for film deposition. Therefore, in the FIB system 100, during deposition of a film, the gas 2 can be efficiently blown against the sample S. Upon the retraction, the nozzle 42 can be placed remotely from the sample S and, therefore, efficient use can be made of the space in the vicinity of the sample S.

In the FIB system 100, the exhaust holes 426 constitute the exhaust path for exhausting the gas 2 in the nozzle 42. When the nozzle 42 is placed at the position for film deposition, the exhaust path is closed. When the nozzle 42 is placed in its retractive position, the exhaust path is opened. Therefore, in the FIB system 100, during film deposition, the gas 2 is blown out from the blowoff port 422. During retraction, the gas 2 remaining in the nozzle 42 can be exhausted from the exhaust holes 426.

In the FIB system 100, when the nozzle 42 is placed at the position for film deposition, the exhaust holes 426 are placed in communication with the sealed chamber 6a. When the nozzle 42 is placed at its retractive position, the exhaust holes 426 are placed in communication with the exhaust chamber 6b that constitutes the exhaust path for exhausting the gas 2 in the nozzle 42. Therefore, in the FIB system 100, the gas 2 remaining in the nozzle 42 can be exhausted by moving the nozzle 42 from the position for film deposition to the retractive position. In this way, in the FIB system 100, placement of the nozzle 42 in its retractive position automatically exhausts the gas 2 staying in the nozzle 42. Therefore, any operation for exhausting the gas 2 staying in the nozzle 42 is dispensed with.

In the FIB system 100, the exhaust path is in communication with the sample chamber 102 where the sample S is placed. Therefore, the FIB system 100 does not need to prepare an additional exhaust system for constituting an exhaust path. Consequently, the gas 2 remaining in the nozzle 42 can be exhausted with a simple structure.

The FIB system 100 includes the receiving tube 46 that receives the nozzle 42. The gap 6 between the receiving tube 46 and the nozzle 42 constitutes the exhaust path for exhausting the gas 2 in the nozzle 42. Therefore, in the FIB system 100, the exhaust path can be created with a simple structure.

In the FIB system 100, the receiving tube 46 is provided with the through-holes 460 in communication with the gap 6. The distance between respective ones of the exhaust holes 426 and the through-holes 460 as taken when the nozzle 42 is in its retractive position is less than the same distance but taken when the nozzle 42 is in the position for film deposition. Therefore, in the FIB system 100, the gas 2 exhausted from the exhaust holes 426 can be efficiently exhausted through the through-holes 460.

In the FIB system 100, the through-holes 460 do not face the sample S. Therefore, in the FIB system 100, the possibility that the gas 2 exhausted from the through-holes 460 into the sample chamber 102 will reach the sample S can be reduced.

The FIB system 100 includes the drive mechanism serving as a control mechanism to vary the conductance of the exhaust path for exhausting the gas 2 in the nozzle 42. In the drive mechanism 48, the exhaust holes 426 can be placed in communication either with the sealed chamber 6a or with the exhaust chamber 6b by moving the nozzle 42. In this way, the drive mechanism 48 functions as the control mechanism for varying the conductance of the exhaust path. Consequently, in the FIB system 100, the amount of the gas 2 blown out of the blowoff port 422 and the amount of the gas 2 expelled from the exhaust holes 426 can be controlled.

In the FIB system 100, the blowoff port 422 is formed in the front end of the nozzle 42. Therefore, in the FIB system 100, the blowoff port 422 can be arranged close to the sample S. In addition, in the FIB system 100, the exhaust holes 426 extend through the side wall of the nozzle 42. Therefore, in the FIB system 100, the gas 2 remaining in the nozzle 42 can be efficiently exhausted.

In the FIB system 100, each exhaust hole 426 is greater in diameter than the blowoff port 422. Therefore, in the FIB system 100, the gas 2 remaining in the nozzle 42 can be efficiently exhausted from the exhaust holes 426.

### 1.5. Modification

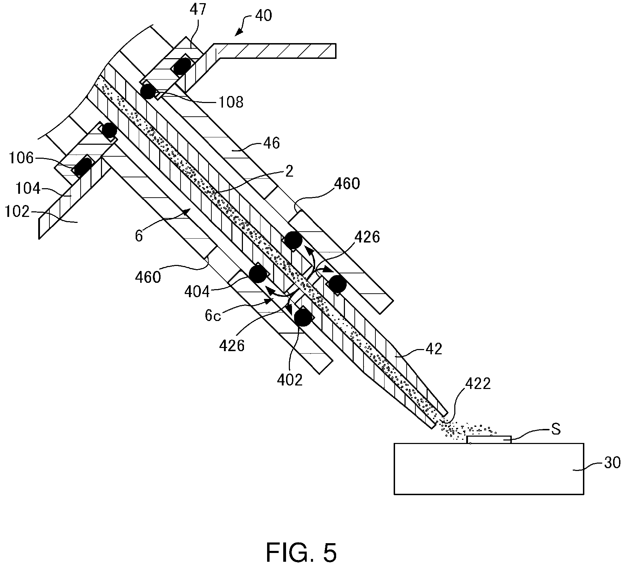

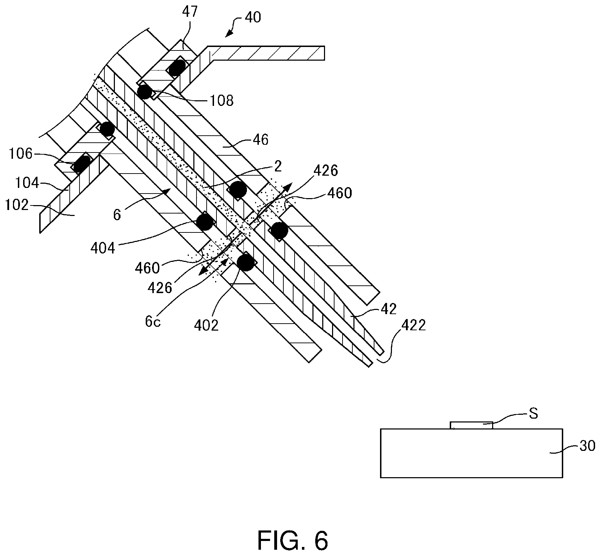

FIGS. 5 and 6 are schematic cross sections of a modification of the focused ion beam system 100. FIG. 5 illustrates a state in which the nozzle 42 is placed in the position for film deposition. FIG. 6 illustrates a state in which the nozzle 42 is placed in its retractive position.

In the above-described first embodiment, the O-rings 402 and 404 are mounted in their respective O-ring grooves formed in the inner wall of the receiving tube 46. In contrast, in the present modification, the O-rings 402 and 404 are mounted in their respective grooves formed in the outer peripheral surface of the nozzle 42 as shown in FIGS. 5 and 6.

The O-rings 402 and 404 move concomitantly with movement of the nozzle 42. Therefore, the space 6c between the O-rings 402 and 404 moves as the nozzle 42 moves. The exhaust holes 426 are present between the O-rings 402 and 404 and in communication with the space 6c.

When the nozzle 42 is placed at the position for film deposition as shown in FIG. 5, the space 6c between the O-rings 402 and 404 is not in communication with the through-holes 460 and the exhaust path is closed. Accordingly, most of the gas 2 supplied from the supply port 424 is blown out from the blowoff port 422.

On the other hand, when the nozzle 42 is placed at its retractive position as shown in FIG. 6, the space 6c is in communication with the through-holes 460 and the exhaust path is opened. Accordingly, the gas 2 remaining in the nozzle 42 can be exhausted into the sample chamber 102 via the exhaust path.

In this way, in the focused ion beam system of the present modification, when the nozzle 42 is placed at its retractive position, the gas 2 remaining in the nozzle 42 can be exhausted into the sample chamber 102 via the exhaust holes 426 and the through-holes 460 in the same way as in the focused ion beam system 100.

### 2. Second Embodiment

### 2.1. Focused Ion Beam System

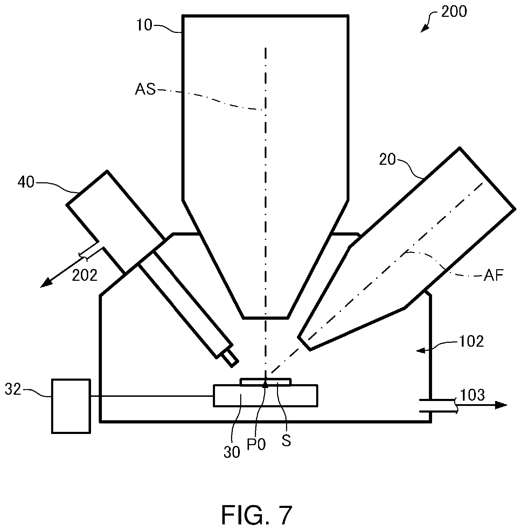

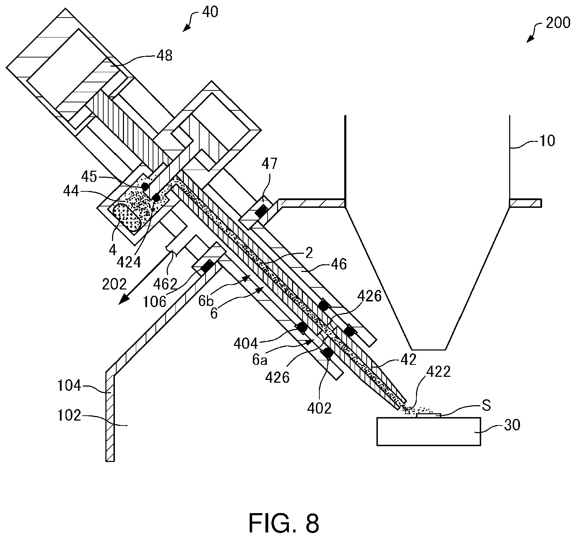

A focused ion beam (FIB) system associated with a second embodiment of the present invention is next described by referring to FIGS. 7 and 8. FIG. 7 shows one example of configuration of the focused ion beam (FIB) system, 200, associated with the second embodiment. FIG. 8 is a schematic cross-sectional view of the gas ejector 40 equipped in the FIB system 200.

In the FIB system 200 associated with the second embodiment, those members which are similar in function to their respective counterparts of the FIB system 100 associated with the first embodiment are indicated by the same reference numerals as in the foregoing figures and a detailed description thereof is omitted.

In the FIB system 100 of FIG. 1, the gas 2 remaining in the nozzle 42 is exhausted into the sample chamber 102 via the exhaust path. In contrast, the FIB system 200 shown in FIG. 7 includes a first exhaust system 103 for exhausting the sample chamber 102 and a second exhaust system 202 for exhausting the interior of the nozzle 42. The second exhaust system 202 is independent of the first exhaust system 103 and is not in communication with the sample chamber 102. In this way, the FIB system 200 is equipped with the dedicated exhaust system for exhausting the gas 2 remaining in the nozzle 42.

As shown in FIG. 8, an exhaust tube 462 in communication with the gap 6 between the nozzle 42 and the receiving tube 46 is connected to the receiving tube 46. The exhaust tube 462 constitutes the second exhaust system 202. The second exhaust system 202 includes vacuum pumping apparatus and a valve (both not shown), as well as the exhaust tube 462. The first exhaust system 103 and the second exhaust system 202 may share common vacuum pumping apparatus.

### 2.2. Operation

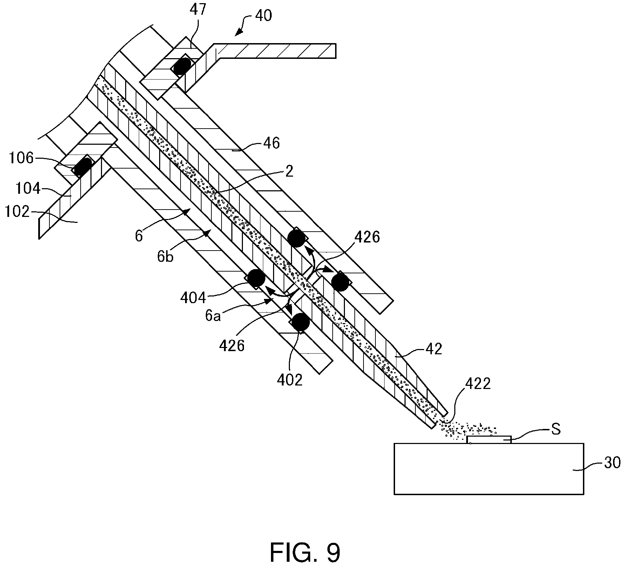

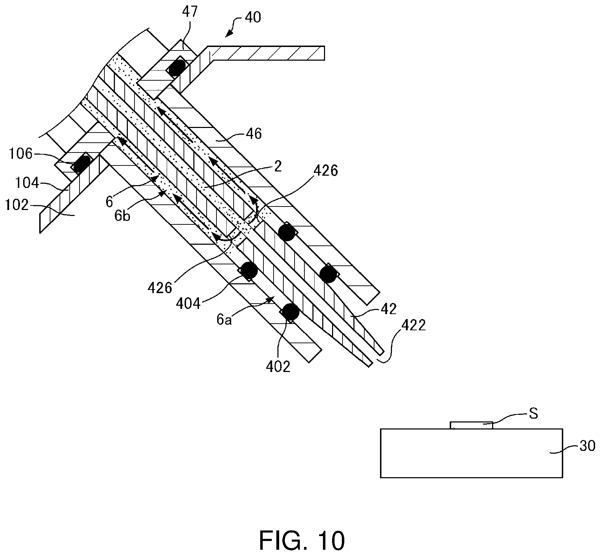

FIGS. 9 and 10 illustrate the operation of the FIB system 200. FIG. 9 illustrates a state in which the nozzle 42 is in the position for film deposition. FIG. 10 illustrates a state in which the nozzle 42 is in its retractive position.

As shown in FIG. 9, if the nozzle 42 is located in the position for film deposition, the exhaust holes 426 are in communication with the sealed chamber 6a and so the exhaust path is closed. Accordingly, if the nozzle 42 is placed in the position for film deposition, most of the gas 2 supplied from the supply port 424 is blown out from the blowoff port 422.

If the nozzle 42 is placed in its retractive position as shown in FIG. 10, the exhaust holes 426 are in communication with the exhaust chamber 6b. Therefore, the exhaust holes 426, exhaust chamber 6b, and exhaust tube 462 together constitute the exhaust path. Thus, the exhaust path is opened by moving the nozzle 42 into its retractive position. The gas 2 remaining in the nozzle 42 can be exhausted from the second exhaust system 202 via the exhaust path.

### 2.3. Advantageous Effects

The FIB system 200 is capable of exhausting the gas 2 remaining in the nozzle 42 in the same way as the above-described FIB system 100. The FIB system 200 includes the first exhaust system 103 for exhausting the sample chamber 102 and the second exhaust system 202 for exhausting the interior of the nozzle 42. Therefore, the FIB system 200 can exhaust the gas 2 remaining in the nozzle 42 to the outside of the sample chamber 102. Consequently, the FIB system 200 can prevent a film from being deposited thickly on the sample S.

### 3. Third Embodiment

### 3.1. Focused Ion Beam System

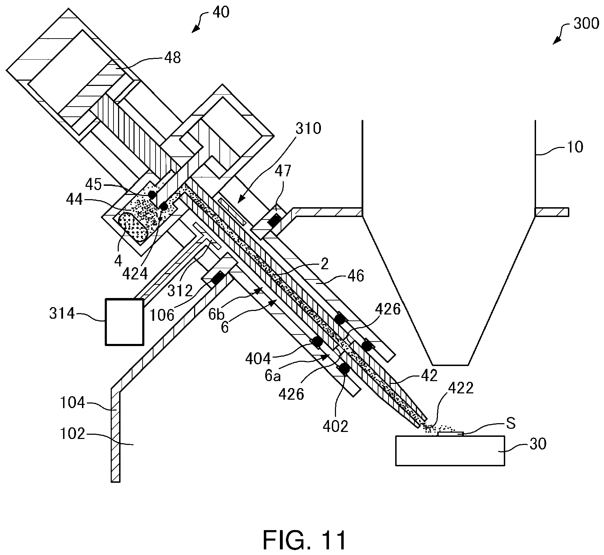

A focused ion beam (FIB) system associated with a third embodiment of the present invention is next described by referring to FIG. 11, which shows one example of configuration of the FIB system associated with the third embodiment. Those members of the FIB system, 300, associated with the third embodiment which are similar in function to their respective counterparts of the FIB systems 100 and 200 associated with the first and second embodiments, respectively, are indicated by the same reference numerals as in the foregoing figures and a detailed description thereof is omitted.

In the above-described FIB system 200 shown in FIGS. 7-10, the gas 2 remaining in the nozzle 42 is exhausted using the second exhaust system 202. On the other hand, in the FIB system 300, the gas 2 remaining in the nozzle 42 is exhausted using a cold trap 310 as shown in FIG. 11.

The cold trap 310 includes a cooling fin 312 and a tank 314 filled with a refrigerant for cooling the cooling fin 312. The cold trap 310 is a device for cooling the cooling fin 312 to condense gas molecules. The cooling fin 312 is mounted in the exhaust chamber 6b. Examples of the refrigerant in the tank 314 include liquid nitrogen and liquid helium.

In the FIB system 300, if the nozzle 42 is placed in its retractive position, the gas 2 remaining in the nozzle 42 can be condensed onto the cold trap 310 via the exhaust holes 426 and the exhaust chamber 6b. Consequently, the gas 2 remaining in the nozzle 42 can be exhausted.

### 3.2. Operation

The operation of the FIB system 300 is similar to the operation of the above-described FIB system 200 except that, when the nozzle 42 is placed in its retractive position, the gas 2 remaining in the nozzle 42 is exhausted by the use of the cold trap 310 and so a description thereof is omitted.

### 3.3. Advantageous Effects

In the FIB system 300, the gas 2 remaining in the nozzle 42 is not exhausted into the sample chamber 102 in the same way as in the above-stated FIB system 200.

### 4. Fourth Embodiment

### 4.1. Focused Ion Beam System

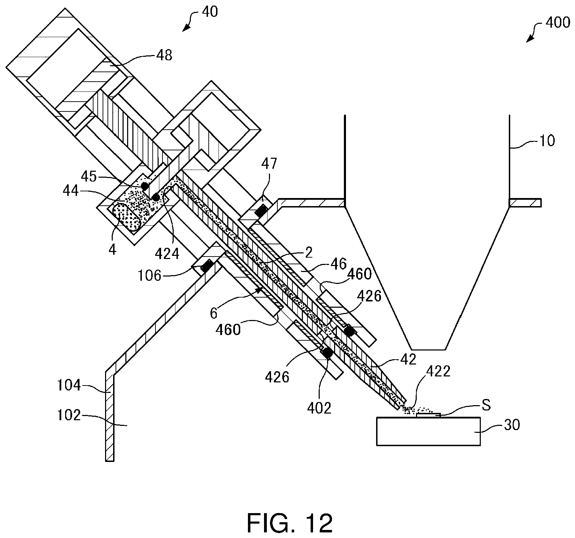

A focused ion beam (FIB) system associated with a fourth embodiment of the present invention is next described by referring to FIG. 12, which shows one example of configuration of the FIB system, 400, associated with the fourth embodiment. Those members of the FIB system 400 which are similar in function to their respective counterparts of the FIB system 100 associated with the first embodiment are indicated by the same reference numerals as in the foregoing figures and a detailed description thereof is omitted.

In the FIB system 100 shown in FIGS. 1-4, if the nozzle 42 is placed at the position for film deposition, the exhaust holes 426 are placed in communication with the sealed chamber 6a and the exhaust path is closed. If the nozzle 42 is placed in its retractive position, the exhaust holes 426 are placed in communication with the exhaust chamber 6b and the exhaust path is opened.

On the other hand, in the FIB system 400, the distance between respective ones of the exhaust holes 426 and the through-holes 460 as taken across the gap 6 is varied by moving the nozzle 42, whereby the conductance of the exhaust path is varied. In particular, if the nozzle 42 is placed in the position for film deposition, the distance between respective ones of the exhaust holes 426 and the through-holes 460 increases. The conductance of the exhaust path is less than that of the front end portion of the nozzle 42. If the nozzle 42 is placed in its retractive position, the distance between respective ones of the exhaust holes 426 and the through-holes 460 decreases. The conductance of the exhaust path is greater than that of the front end portion of the nozzle 42.

The FIB system 400 does not have the rear O-ring 404. The sealed chamber 6a is not formed in the gap 6 between the nozzle 42 and the receiving tube 46. In the FIB system 400, the gap 6 is narrow and thus the gas 2 does not flow smoothly. That is, the exhaust conductance of the gap 6 is small.

### 4.2. Operation

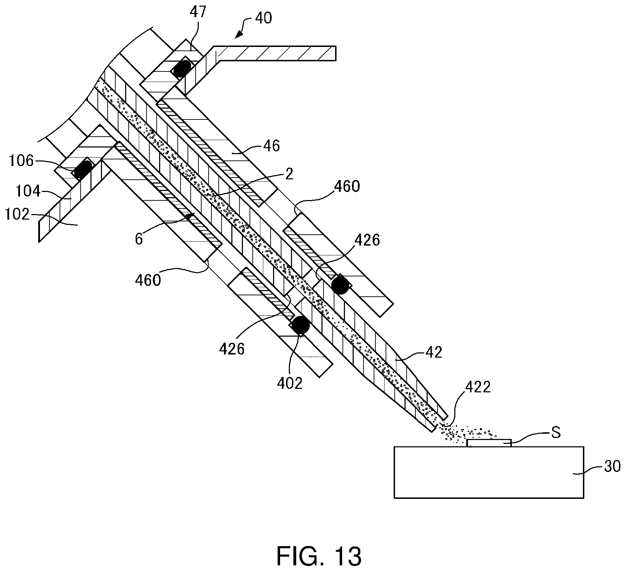

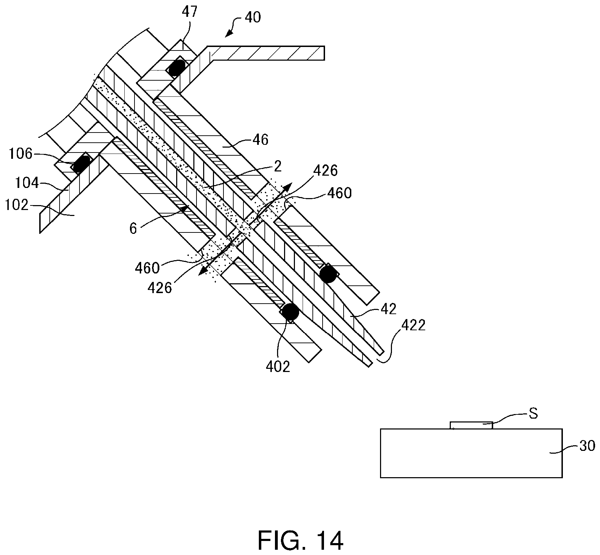

FIGS. 13 and 14 illustrate the operation of the FIB system 400. FIG. 13 illustrates a state in which the nozzle 42 is in the position for film deposition. FIG. 14 illustrates a state in which the nozzle 42 is in its retractive position.

If the nozzle 42 is placed at the position for film deposition as shown in FIG. 13, the exhaust holes 426 come into communication with the gap 6. At this time, the exhaust path is constituted by the exhaust holes 426, gap 6, and through-holes 460. If the nozzle 42 is placed at the position for film deposition, the distance between respective ones of the exhaust holes 426 and the through-holes 460 is large. The gap 6 forming the exhaust path for the gas 2 and interconnecting the exhaust holes 426 and the through-holes 460 is long. Therefore, the conductance of the front end portion of the nozzle 42 is larger than that of the exhaust path. Accordingly, if the nozzle 42 is placed at the position for film deposition, most of the gas 2 supplied from the supply port 424 is blown out from the blowoff port 422.

If the nozzle 42 is placed at its retractive position as shown in FIG. 14, the exhaust holes 426 are placed in communication with the gap 6 in the same way as when the nozzle 42 is placed at the position for film deposition. The distance between respective ones of the exhaust holes 426 and the through-holes 460 as taken when the nozzle 42 is placed at its retractive position is less than the same distance but taken when the nozzle 42 is placed at the position for film deposition. Therefore, the length of the gap 6 constituting the exhaust path for the gas 2 and interconnecting the exhaust holes 426 and the through-holes 460 can be shortened. For this reason, the conductance of the exhaust path can be made larger than that of the front end portion of the nozzle 42. Consequently, when the nozzle 42 is placed at its retractive position, the gas 2 remaining in the nozzle 42 can be discharged into the sample chamber 102 via the exhaust path.

In the example shown in FIG. 13, if the nozzle 42 is placed at the position for film deposition, the exhaust holes 426 and the through-holes 460 are not in registry as viewed along the central axis of the exhaust holes 426. On the other hand, in the example shown in FIG. 14, if the nozzle 42 is placed at its retractive position, the exhaust holes 426 and the through-holes 460 are in registry with each other as viewed along the central axis of the exhaust holes 426. Accordingly, when the nozzle 42 is placed at its retractive position, the gas 2 exhausted from the exhaust holes 426 can be efficiently expelled into the sample chamber 102 via the through-holes 460.

In this way, when the nozzle 42 is placed at the position for film deposition, the conductance of the front end portion of the nozzle 42 is greater than that of the exhaust path. Therefore, the amount of the gas 2 blown out from the blowoff port 422 can be made larger than that of the gas 2 exhausted from the exhaust holes 426. When the nozzle 42 is placed at its retractive position, the conductance of the exhaust path is greater than that of the front end portion of the nozzle 42. Therefore, the amount of the gas 2 exhausted from the exhaust holes 426 can be made larger than that of the gas 2 blown out from the blowoff port 422. The drive mechanism 48 for moving the nozzle 42 functions as a control mechanism for varying the conductance of the exhaust path.

### 4.3. Advantageous Effects

In the FIB system 400, the distance between respective ones of the exhaust holes 426 and the through-holes 460 as taken when the nozzle 42 is in its retractive position is less than the same distance but taken when the nozzle 42 is in the position for film deposition. Therefore, in the FIB system 400, the conductance of the exhaust path as taken when the nozzle 42 is placed at its retractive position can be made larger than that of the exhaust path as taken when the nozzle 42 is placed at the position for film deposition. Consequently, the FIB system 400 can exhaust the gas 2 remaining in the nozzle 42 when the nozzle 42 is placed at its retractive position in the same manner as the above-described FIB system 100.

### 5. Fifth Embodiment

### 5.1. Focused Ion Beam System

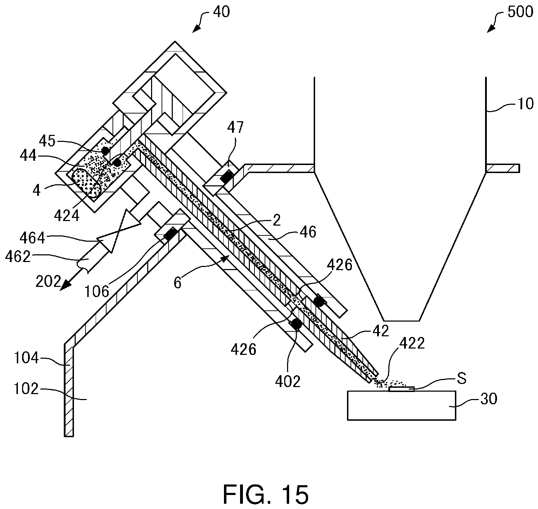

A focused ion beam (FIB) system associated with a fifth embodiment of the present invention is next described by referring to FIG. 15, which shows one example of configuration of the FIB system, 500, associated with the fifth embodiment. Those members of the FIB system 500 which are similar in function to their respective counterparts of the FIB systems 100 and 200 respectively associated with the first and second embodiments are indicated by the same reference numerals as in the foregoing figures and a detailed description thereof is omitted.

In the above-described FIB system 100 of FIGS. 1-4, the gas ejector 40 has the drive mechanism 48 for moving the nozzle 42. In contrast, the FIB system 500 does not have the drive mechanism 48 as shown in FIG. 15. The nozzle 42 is fixed in position.

Furthermore, in the FIB system 100, the gap 6 between the nozzle 42 and the receiving tube 46 is partitioned into the sealed chamber 6a and the exhaust chamber 6b. In contrast, in the FIB system 500, the gap 6 is not partitioned but is a single space. The exhaust holes 426 and the exhaust tube 462 are in communication with the gap 6.

The gas ejector 40 includes the exhaust tube 462 connected to the gap 6 and a valve 464 mounted in the exhaust tube 462 as shown in FIG. 15. The exhaust tube 462 and the valve 464 together constitute a second exhaust system 202.

For example, the valve 464 is a gate valve which partitions the interior of the exhaust tube 462 and which opens and closes. The exhaust path for the gas 2 remaining in the nozzle 42 is constituted by the exhaust holes 426 and the gap 6. By opening the valve 464, the exhaust tube 462 is placed in communication with the gap 6. Under this condition, the gas 2 remaining in the nozzle 42 can be exhausted by the second exhaust system 202 via the exhaust path. By closing the valve 464, the second exhaust system 202 and the exhaust path are not placed in communication, and evacuation of the interior of the nozzle 42 can be brought to a stop.

### 5.2. Operation

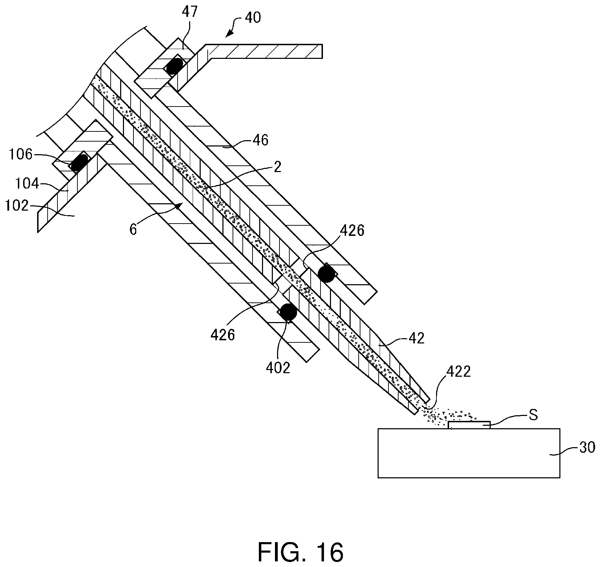

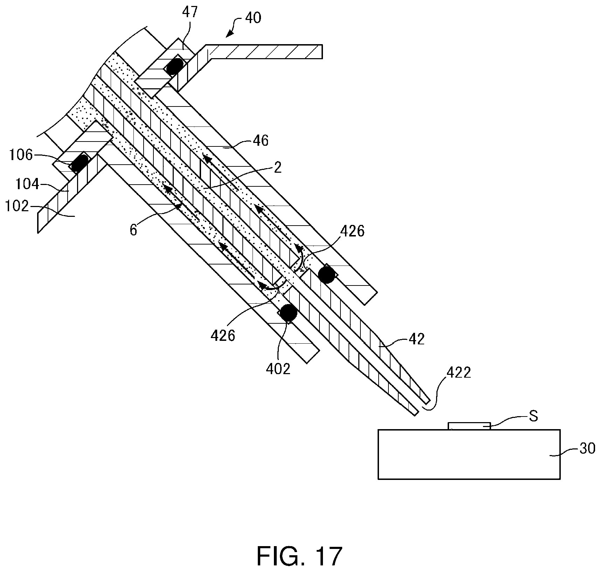

FIGS. 16 and 17 illustrate the operation of the FIB system 400. FIG. 16 is a schematic cross section of the gas ejector 40 when a film is deposited on the sample S. FIG. 17 is a schematic cross section of the gas ejector 40 when the gas 2 remaining in the nozzle 42 is exhausted.

Where a film is deposited, the valve 464 is closed to close the exhaust path. Consequently, as shown in FIG. 16, the gas 2 is not exhausted from the exhaust holes 426. Most of the gas 2 supplied from the supply port 424 is blown out from the blowoff port 422.

As a result, the gas 2 can be blown against the sample S and a film can be deposited on the sample S.

Where the gas 2 remaining in the nozzle 42 is exhausted, the valve 464 is opened to open the exhaust path. Consequently, as shown in FIG. 17, the gas 2 remaining in the nozzle 42 can be exhausted from the second exhaust system 202 via the exhaust path.

### 5.3. Advantageous Effects

The FIB system 500 includes the valve 464 for opening and closing the exhaust path. Therefore, the FIB system 500 can exhaust the gas 2 remaining in the nozzle 42 in the same manner as the FIB system 100.

### 5.4. Modification

The above-described FIB system 500 is equipped with the valve 464 for opening and closing the exhaust path. The valve 464 may be used to adjust the flow rate. For example, the valve 464 may be a needle valve capable of adjusting the flow rate. There is no restriction on the valve 464 as long as the flow rate can be adjusted. For instance, a well-known flow rate adjusting valve such as an orifice valve capable of adjusting the flow rate can be used.

Where a film is deposited, the valve 464 is so adjusted that the conductance of the exhaust path is less than that of the front end portion of the nozzle 42. As a result, most of the gas 2 supplied from the supply port 424 is blown out from the blowoff port 422, and a film can be deposited on the sample S.

Where the gas 2 remaining in the nozzle 42 is exhausted, the valve 464 is so adjusted that the conductance of the exhaust path is greater than that of the front end portion of the nozzle 42. Consequently, the gas 2 remaining in the nozzle 42 can be exhausted from the second exhaust system 202 via the exhaust path. In this way, the valve 464 functions as a control mechanism for varying the conductance of the exhaust path.

In the above-described modification, the conductance of the exhaust path is varied using the valve 464 capable of adjusting the flow rate. The mechanism that varies the conductance of the exhaust path is not restricted to a valve. For example, the conductance of the exhaust path may be varied by designing the diameter of the exhaust holes 426 or the size of the gap 6 to be variable and changing the diameter or size.

### 6. Others

Note that the present invention is not restricted to the foregoing embodiments but rather can be practiced in variously modified forms without departing from the gist of the present invention.

In the above-described first embodiment, the FIB system 100 is equipped with both the SEM column 10 and the FIB column 20. However, the FIB system 100 does not need to have the SEM column 10. The same principle also applies to the FIB systems associated with the second to fifth embodiments. That is, these FIB systems do not need to have the SEM column 10.

It is to be understood that the foregoing embodiments and modifications are merely exemplary and that the present invention is not restricted thereto. For example, the embodiments and modifications can be combined appropriately.

The present invention is not restricted to the foregoing embodiments but rather implemented in variously modified forms. For example, the present invention embraces configurations (e.g., configurations identical in function and method) which are substantially identical to the configurations described in the above embodiments. Furthermore, the present invention embraces configurations which are similar to the configurations described in the above embodiments except that their nonessential portions have been replaced. Further, the present invention embraces configurations which are similar to the configurations described in any one of the above embodiments except that a well-known technique is added.

## Claims

1. A focused ion beam system for milling a sample by irradiating the sample with an ion beam, said focused ion beam system comprising:
a nozzle for blowing a gas, which is used to deposit a film, from a blowoff port against the sample;
a tank for supplying the gas into the nozzle; and
exhaust holes formed in the nozzle to exhaust the gas in the nozzle.

2. A focused ion beam system as set forth in claim 1, further comprising:
a drive mechanism capable of moving said nozzle between a position for film deposition where the gas can be blown from said blowoff port against said sample and a retractive position different from the position for film deposition.

3. A focused ion beam system as set forth in claim 2, wherein said exhaust holes constitute an exhaust path for exhausting the gas in said nozzle, and wherein, when the nozzle is placed in said position for film deposition, the exhaust path is closed and, when the nozzle is placed in said retractive position, the exhaust path is opened.

4. A focused ion beam system as set forth in any one of claims 2 and 3,
wherein, when said nozzle is placed in said position for film deposition, said exhaust holes are placed in communication with a sealed chamber that has been hermetically sealed; and
wherein, when the nozzle is placed in said retractive position, the exhaust holes are placed in communication with an exhaust chamber that constitutes the exhaust path for exhausting the gas in the nozzle.

5. A focused ion beam system as set forth in any one of claims 3 and 4, wherein said exhaust path is in communication with a sample chamber where said sample is placed.

6. A focused ion beam system as set forth in any one of claims 3 and 4, further comprising a first exhaust system for exhausting a sample chamber where said sample is placed and a second exhaust system for exhausting the interior of said nozzle.

7. A focused ion beam system as set forth in any one of claims 2 to 6, further comprising a receiving tube for receiving said nozzle, and wherein a space between the nozzle and the receiving tube constitutes an exhaust path for exhausting the gas in the nozzle.

8. A focused ion beam system as set forth in claim 7, wherein said receiving tube is provided with through-holes in communication with said space, and wherein the distance between respective ones of the exhaust holes and the through-holes as taken when the nozzle is placed in said retractive position is less than the distance between respective ones of the exhaust holes and the through-holes as taken when the nozzle is placed in said position for film deposition.

9. A focused ion beam system as set forth in claim 8, wherein said through-holes do not face said sample.

10. A focused ion beam system as set forth in any one of claims 1 and 2, wherein the exhaust path for exhausting the gas in said nozzle has a conductance, and wherein there is further provided a control mechanism for varying the conductance of the exhaust path.

11. A focused ion beam system as set forth in any one of claims 1 to 10, wherein said blowoff port is formed in a front end of said nozzle.

12. A focused ion beam system as set forth in any one of claims 1 to 11, wherein said exhaust holes extend through a side wall of said nozzle.

13. A focused ion beam system as set forth in any one of claims 1 to 12, wherein each of said exhaust holes is greater in diameter than said blowoff port.
